# EUROPEAN PATENT SPECIFICATION

(11) **EP 3 132 932 B1**
(45) Date of publication and mention of the grant of the patent: **15.04.2020**
(21) Application number: 16180909.0
(22) Date of filing: 22.07.2016
(51) Int. Cl.: B41C 1/10, G03F 7/027, G03F 7/028, G03F 7/029

(54) **LITHOGRAPHIC IMAGING AND PRINTING WITH NEGATIVE-WORKING PHOTORESPONSIVE PRINTING MEMBERS**
LITHOGRAFISCHE ABBILDUNG UND DRUCKEN MIT NEGATIV ARBEITENDEN FOTOREAKTIVEN DRUCKELEMENTEN
IMAGERIE ET IMPRESSION LITHOGRAPHIQUES AVEC ÉLÉMENTS D'IMPRESSION PHOTOSENSIBLES NÉGATIFS

(30) Priority: 24.07.2015 US 201514808106
(43) Date of publication of application: 22.02.2017
(73) Proprietor: Presstek, LLC., Hudson NH 03051-4922 (US)
(72) Inventor: RAY, Kevin, Windham, NH New Hampshire 03087 (US); SYPEK, Maria, Belchertown, MA Massachusetts 01007 (US); SOFTIC, Travis, Springfield, MA Massachusetts 01119 (US); NGUYEN, Thuan, Springfield, MA Massachusetts 01108 (US); KARP, Michael, 4974233 Petah Tikva (IL); ETZIONY, Oren, 2521000 Ein Hamifratz (IL); ZEGNIOYEV, Geula, 2224705 Nahariya (IL)
(74) Representative: Somervell, Thomas Richard

(56) References cited:
- EP-A1- 1 653 281
- US-A1- 2009 047 599
- US-B2- 6 582 882
- US-B2- 6 899 994

## Description

### Background of the Invention

In offset lithography, a printable image is present on a printing member as a pattern of ink-accepting (oleophilic) and ink-rejecting (oleophobic) surface areas. Once applied to these areas, ink can be efficiently transferred to a recording medium in the imagewise pattern with substantial fidelity. In a wet lithographic system, the non-image areas are hydrophilic, and the necessary ink-repellency is provided by an initial application of a dampening fluid to the plate prior to inking. The dampening fluid prevents ink from adhering to the non-image areas, but does not affect the oleophilic character of the image areas. Ink applied uniformly to the wetted printing member is transferred to the recording medium only in the imagewise pattern. Typically, the printing member first makes contact with a compliant intermediate surface called a blanket cylinder which, in turn, applies the image to the paper or other recording medium. In typical sheet-fed press systems, the recording medium is pinned to an impression cylinder, which brings it into contact with the blanket cylinder.

To circumvent the cumbersome photographic development, plate-mounting, and plate-registration operations that typify traditional printing technologies, practitioners have developed electronic alternatives that store the imagewise pattern in digital form and impress the pattern directly onto the plate. Plate-imaging devices amenable to computer control include various forms of lasers.

In negative-working plates, the foreground or image (as opposed to background) areas of the plate receive exposure to a laser or other source of imaging radiation. The effect of radiation exposure depends on the nature of the plate. For example, where plates are "developed" by subjecting them to the action of a liquid developer following exposure, radiation either "fixes" the topmost layer to render it resistant to the developer (which washes away the unexposed areas) or has the opposite effect, rendering an otherwise developer-resistant layer vulnerable to developer action. Suppose the plate is configured for wet printing and has two layers, an oleophilic layer to receive ink and a hydrophilic layer to receive fountain solution or other aqueous liquid that repels subsequently applied ink; the ink-receiving areas are foreground or image, and areas that do not receive ink are considered background. Because the plate is negative-working, the radiation either renders the oleophilic layer unremovable by development or renders the hydrophilic layer removable. Most negative-working wet plates utilize the former mechanism. Examples of known negative working printing members and systems are described in documents EP1653281 and US2009/0047599.

For example, a topmost oleophilic, photoresponsive layer maybe sensitized to light in the near-infrared (IR) region, thus allowing the use of a modulated near-IR laser to imagewise write a developable pattern on the photoresponsive coating. The substrate may be aluminum with an anodized oxide layer to provide a hydrophilic and mechanically durable surface. Once exposed, the plate is treated with a developing liquid to remove those areas that have not received exposure while leaving the imaged areas unaffected. Removal of the oleophilic photoresponsive coating reveals the hydrophilic aluminum layer, which will serve as the background and reject ink during printing.

Although some IR-imaged plates are developed with water rather than a solvent-based developer, the photoresponsive layer in such plates is generally not polymerized by imaging radiation. Instead, the photoresponsive layer may contain microspheres or beads of thermally fusible material suspended in a water-soluble medium or matrix. Such plates are imaged at high energy levels, causing the microspheres fuse to themselves and to the substrate. The imaged plates can be developed with water, whereby the imaged, fused areas remain intact whereas the unimaged, unfused areas (including microspheres) are removed via dissolution of the matrix. Not only is a high level of energy required for imaging such plates, but the rate of imaging tends to be slow and the resolution low.

The water-soluble materials that are used in the photoresponsive layer typically comprise polymers, monomers, and various components of the initiator system and in some cases additives. Water-soluble materials aid in the post-development enhancement of printing performance that takes place on-press, often referred to as print "make-ready." These materials ensure that the unimaged areas of the plate are completely "cleaned out" and remain water-receptive. An unfortunate consequence of this mechanism is that the water-soluble materials tend to dissolve in and contaminate the fountain solution, producing highly colored defects in the printed copy. In addition, water-soluble materials also act as emulsifiers, which can cause the ink to emulsify in the fountain solution. As a consequence, the ink and water do not properly function lithographically, i.e., ink "scums" the background areas while failing properly to adhere to the image areas. Finally, the presence of water-soluble materials may additionally weaken the construct of the imaged/hardened layer as the water-soluble chemicals leach out into the press fountain solution during the printing process.

### Summary of the Invention

According to the present invention there is provided a method of preparing and printing with a lithographic printing member as set forth in claim 1 and a lithographic printing member as set forth in claim 10. The present invention is directed toward reducing or eliminating water-soluble materials from the photoresponsive layer without losing the post-imaging benefits that these materials confer. It has been found that these objectives can be achieved through the use of a radiation-sensitive composition having a component polymerizable by a free-radical mechanism, at least part of which comprises or consists essentially of a non-particulate, aliphatic urethane acrylic oligomer that is infinitely water-dilutable but not water-soluble. In fact it is found, surprisingly, that make-ready is actually improved (i.e., the necessary number of make-ready impressions is reduced without the image degradation produced by water-soluble materials).

As used herein, the term "free radical" refers to a highly reactive atom or molecule with at least one unpaired electron. A "free-radical polymerization mechanism" means initiation of polymerization by free radicals that attack short-chain oligomers with ethylenic unsaturation; these free radical species are known as "free-radical initiators."

The term "oligomer" herein connotes a small polymeric molecule containing only a few (typically fewer than 20, and often fewer than six) monomer units. A "urethane acrylate oligomer" is a polymerizable species containing at least two monomeric units that themselves include urethane (NH-(C=O)-O-) and acrylate (CH₂=CH-(C=O)-O-) functional groups. An exemplary structure is: 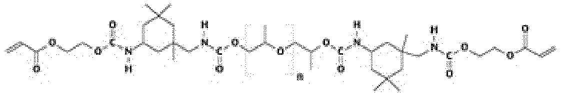 where the terminal ethylene groups are further polymerizable by free-radical initiators. References to an "oligomer" or a "monomer" generally refer to quantities of the oligomer or monomer species (rather than to single molecules thereof).

By "aliphatic" is meant organic compounds whose carbon atoms are linked in open chains, either straight or branched, or in a cyclic ring that may itself have side chains. Hence, the methylene groups in the oligomer structure above may be replaced with straight or branched chains with additional carbon atoms.

"Water-dilutable" has the same meaning as "water-reducible," referring to a material that may be diluted with water - i.e., its concentration may be reduced uniformly by addition of water. A material that is water-dilutable without being water-soluble means that the material disperses uniformly in water but remains as a separate phase (that may, for example, be filtered) with a particle size of at least 1 nm and in some cases at least 1 µm, with water as the continuous phase. A material that is infinitely water-dilutable disperses uniformly in water regardless of the volume of water relative to that of the infinitely water-dilutable material.

An "onium salt" is an ionic compound of the general formula (Rₙ₊₁M)⁺X⁻where R is an organic radical or hydrogen; M represents an atom of nitrogen, phosphorus, oxygen and so on (ammonium, phosphonium, oxonium, and other compounds); X is an anion; and n denotes the lowest valence number of M in organic compounds. An onium atom of M may be part of a heterocyclic compound, e.g., a salt of pyridinium.

The term "plate" or "member" refers to any type of printing member or surface capable of recording an image defined by regions exhibiting differential affinities for ink and/or fountain solution. Suitable configurations include the traditional planar or curved lithographic plates that are mounted on the plate cylinder of a printing press, but can also include seamless cylinders (e.g., the roll surface of a plate cylinder), an endless belt, or other arrangement.

The term "hydrophilic" is used in the printing sense to connote a surface affinity for a fluid which prevents ink from adhering thereto. Such fluids include water for conventional ink systems, aqueous and non-aqueous dampening liquids, and the non-ink phase of single-fluid ink systems. Thus, a hydrophilic surface in accordance herewith exhibits preferential affinity for any of these materials relative to oil-based materials.

The term "substantially" or "approximately" means ±10% (e.g., by weight or by volume), and in some embodiments, ±5%. The term "consists essentially of' means excluding other materials that contribute to function or structure. For example, a radiation-sensitive composition consisting essentially of a polymerizable component, an initiator composition, a radiation-absorbing component and a polymeric binder may include other ingredients, such as a catalyst, that may perform important functions but do not constitute part of the polymer structure of the composition following polymerization. Percentages refer to weight percentages unless otherwise indicated.

### Description of Drawings

The foregoing discussion will be understood more readily from the following detailed description of the disclosed technology, when taken in conjunction with the single figure of the drawing, which is an enlarged cross-sectional view of a positive-working printing member according to the invention.

### Detailed Description

### 1. Imaging Apparatus

The coated plate is imaged in an imaging device, typically by means of a modulated signal, e.g., a modulated near-IR laser. The laser is rastered over the plate surface while the laser intensity is modulated according to digital information so that only the background areas of the plate receive exposure. An imaging apparatus suitable for use in conjunction with the present printing members includes at least one laser device that emits in the region of maximum plate responsiveness, i.e., whose λₘₐₓ closely approximates the wavelength region where the plate absorbs most strongly. Specifications for lasers that emit in the near-IR region are fully described in U.S. Patent Nos. Re. 35,512 ("the '512 patent") and 5,385,092 ("the '092 patent"). Lasers emitting in other regions of the electromagnetic spectrum are well-known to those skilled in the art.

Suitable imaging configurations are also set forth in detail in the '512 and '092 patents. Briefly, laser output can be provided directly to the plate surface via lenses or other beam-guiding components, or transmitted to the surface of a blank printing plate from a remotely sited laser using a fiber-optic cable. A controller and associated positioning hardware maintain the beam output at a precise orientation with respect to the plate surface, scan the output over the surface, and activate the laser at positions adjacent selected points or areas of the plate. The controller responds to incoming image signals corresponding to the original document or picture being copied onto the plate to produce a precise negative or positive image of that original. The image signals are stored as a bitmap data file on a computer. Such files may be generated by a raster image processor ("RIP") or other suitable means. For example, a RIP can accept input data in page-description language, which defines all of the features required to be transferred onto the printing plate, or as a combination of page-description language and one or more image data files. The bitmaps are constructed to define the hue of the color as well as screen frequencies and angles.

The level of the exposure depends on the power of the laser, the size of the laser spot, and the composition of the coating, but is preferably chosen to deliver an area energy density or fluence between 100 and 250 mJ/cm2, and more preferably between 125 and 200 mJ/cm². Examples of suitable exposure devices are the COMPASS 8030 and the DIMENSION PRO 800, both provided by Presstek Inc. Other imaging systems, such as those involving light valving and similar arrangements, can also be employed; see, e.g., U.S. Patent Nos. 4,577,932; 5,517,359; 5,802,034; and 5,861,992. Moreover, it should also be noted that image spots may be applied in an adjacent or in an overlapping fashion.

The imaging device is typically integrated into a platemaker, which exposes the plates, and following exposure, the plate is transferred to a press, where development takes place during the make-ready process. Importantly, it is unnecessary to use a processor or other equipment that subjects the plate to the action of a developer composition to remove the exposed portions of the imageable coating.

### 2. Lithographic Printing Members

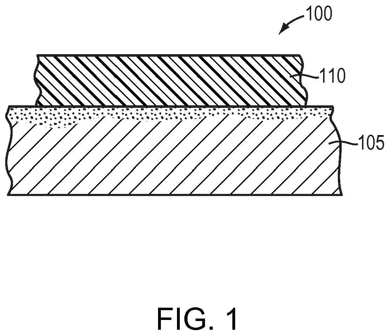

FIG. 1 illustrates a negative-working printing member 100 according to the invention that includes a a hydrophilic substrate 105 and an oleophilic photoresponsive layer 110. Layer 110 is sensitive to imaging (generally IR) radiation as discussed below, and imaging of the printing member 100 (by exposure to IR radiation) renders the layer insoluble when subjected to fountain solution. Most or all of the layers used in the present invention are continuous. The term "continuous" as used herein means that the underlying surface is completely covered with a uniform layer of the deposited material. Each of the layers and its functions are described in detail below.

### 2.1 Substrate 105

The substrate provides dimensionally stable mechanical support to the printing member. The substrate should be strong, stable, and flexible. One or more surfaces (and, in some cases, bulk components) of the substrate is hydrophilic, and the substrate itself is desirably metal. In general, metal layers undergo special treatment in order to be capable of accepting fountain solution in a printing environment. Any number of chemical or electrical techniques, in some cases assisted by the use of fine abrasives to roughen the surface, may be employed for this purpose. For example, electrograining involves immersion of two opposed aluminum plates (or one plate and a suitable counterelectrode) in an electrolytic cell and passing alternating current between them. The result of this process is a finely pitted surface topography that readily adsorbs water. See, e.g., U.S. Patent No. 4,087,341.

A structured or grained surface can also be produced by controlled oxidation, a process commonly called "anodizing." An anodized aluminum substrate consists of an unmodified base layer and a porous, "anodic" aluminum oxide coating thereover; this coating readily accepts water. Without further treatment, however, the oxide coating would lose wettability due to further chemical reaction. Anodized plates are, therefore, typically exposed to a silicate solution or other suitable (e.g., phosphate) reagent that stabilizes the hydrophilic character of the plate surface. In the case of silicate treatment, the surface may assume the properties of a molecular sieve with a high affinity for molecules of a definite size and shapeincluding, most importantly, water molecules. The treated surface also promotes adhesion to an overlying photopolymer layer. Anodizing and silicate treatment processes are described in U.S. Patent Nos. 3,181,461 and 3,902,976. The anodizing thickness is preferably 0.4 to 3 µm thick (as measured by scanning electron microscopy), more preferably 0.7 to 1.5 µm thick, and ideally about 1 µm thick.

Preferred hydrophilic substrate materials include aluminum that has been mechanically, chemically, and/or electrically grained with subsequent anodization. The surface of substrate 105 has characteristics matched to performance of the overlying layer. The thickness of substrate 105 generally ranges from 0.004 to 0.02 inch, with thicknesses in the range 0.005 to 0.012 inch being particularly preferred.

In other embodiments, the hydrophilic surface is provided by a layer that does not itself serve as a substrate - e.g., which is laminated or coated onto a heavier substrate layer.

### 2.2 Photoresponsive Layer 110

Layer 110 is typically applied as a coating and includes a component polymerizable by a free-radical mechanism, at least part of which comprises or consists essentially of a non-particulate, aliphatic urethane acrylic oligomer that is infinitely water-dilutable but not water-soluble, in some embodiments with additional, optional monomer; an initiator; a polymeric binder; and a radiation-absorbing component. The radiation absorber may be a dye, and the composition may also contain one or more additives such as, for example, a coating surfactant. The amount of polymerizable component (i.e., total amount of aliphatic urethane acrylic oligomer and all other monomer) may be high, e.g., about 60 to 80 wt% (and more preferably, 64 to 74 wt%) of the dry film. Surprisingly, this range produces good results and the film is not tacky, notwithstanding what might be expected with this amount of semi-solid material in the layer.

The polymerizable component comprises, consists essentially of or consists of one or more compounds that have one or more ethylenically unsaturated polymerizable or crosslinkable groups that can be polymerized or crosslinked using free-radical initiation. For example, the polymerizable component can be ethylenically unsaturated monomers, oligomers, and crosslinkable polymers, or various combinations of such compounds. Thus, suitable ethylenically unsaturated compounds that can be polymerized or crosslinked include ethylenically unsaturated polymerizable monomers that have one or more of the polymerizable groups, including unsaturated esters of alcohols, such as (meth)acrylate esters of polyols. Oligomers and/or prepolymers, such as urethane (meth)acrylates, epoxide(meth)acrylates, polyester(meth)acrylates, polyether(meth)acrylates, free-radical crosslinkable polymers, and unsaturated polyester resins can also be used. In some embodiments, the polymerizable component may comprise carboxy groups.

Useful polymerizable components include free-radical polymerizable monomers or oligomers that comprise addition polymerizable ethylenically unsaturated groups including multiple acrylate and methacrylate groups and combinations thereof, or free-radical crosslinkable polymers, or combinations of these classes of materials. More particularly useful polymerizable compounds include those derived from urea urethane(meth)acrylates or urethane(meth)acrylates having multiple polymerizable groups. For example, a suitable polymerizable component can be prepared by reacting DESMODUR N100 aliphatic polyisocyanate resin based on hexamethylene diisocyanate (Bayer Corp., Milford, Conn.) with hydroxyethyl acrylate and pentaerythritol triacrylate. Other preferred polymerizable compounds are available from Sartomer Company, Inc. such as SR399 (dipentaerythritol pentaacrylate), SR355 (di-trimethylolpropane tetraacrylate), SR295 (pentaerythritol tetraacrylate), and others that would be readily apparent to one skilled in the art. Also useful are urea urethane(meth)acrylates and urethane(meth)acrylates described in U.S. Patent Nos. 6,582,882 and 6,899,994. In the present invention, at least a portion (and in some embodiments all) of the polymerizable component consists of, or consists essentially of, a non-particulate, aliphatic urethane acrylic oligomer that is infinitely water-dilutable but not water soluble.

Numerous other polymerizable compounds are known to those skilled in the art and are described in the considerable literature including Photoreactive Polymers: The Science and Technology of Resists, A Reiser, Wiley, N.Y., 1989, pp. 102-177; B. M. Monroe in Radiation Curing: Science and Technology, S. P. Pappas, Ed., Plenum, N.Y., 1992, pp. 399-440; and "Polymer Imaging" by A. B. Cohen and P. Walker, in Imaging Processes and Material, J. M. Sturge et al. (Eds.), Van Nostrand Reinhold, New York, 1989, pp. 226-262. For example, useful polymerizable components are also described in EP 1,182,033 beginning with paragraph [0170].

The polymerizable component is present in the photoresponsive composition in an amount sufficient to render the composition insoluble in an aqueous medium after exposure to radiation. This is generally from 20 to 75 wt% and preferably from 40 to 75 wt% based on the dry weight of the photoresponsive composition. For example, the weight ratio of polymerizable component to the polymeric binder may be from 5:1 to 1:1, preferably 3.7:1.

The initiator composition is capable of generating radicals sufficient to initiate polymerization of the polymerizable component upon exposure to the imaging radiation. The initiator composition may be responsive, for example, to electromagnetic radiation in the ultraviolet, visible and/or infrared spectral regions, corresponding to the broad spectral range of from 150 nm to 1500 nm. UV and visible light sensitivity is generally from 150 nm to 700 nm. Preferably, the initiator composition is responsive to IR or near-IR radiation in the range of from 600 nm to 1300 nm, e.g., in the range of from 700 nm to 1200 nm. There are numerous compounds known in the literature that can be used in this manner including, but not limited to, organic boron salts, s-triazines, benzoyl-substituted compounds, onium salts, trihaloalkyl-substituted compounds, metallocenes (such as titanocenes), ketoximes, thio compounds, organic peroxides, or a combination of two or more of these classes of compounds.

Other suitable initiator compositions comprise compounds that include but are not limited to, amines (such as alkanol amines), thiol compounds, anilinodiacetic acids or derivatives thereof, N-phenyl glycine and derivatives thereof, N,N-dialkylaminobenzoic acid esters, N-arylglycines and derivatives thereof (such as N-phenylglycine), aromatic sulfonylhalides, trihalogenomethylsulfones, imides (such as N-benzoyloxyphthalimide), diazosulfonates, 9,10-dihydroanthracene derivatives, N-aryl, S-aryl, or O-aryl polycarboxylic acids with at least 2 carboxy groups of which at least one is bonded to the nitrogen, oxygen, or sulfur atom of the aryl moiety (such as aniline diacetic acid and derivatives thereof and other "co-initiators" described in U.S. Patent No. 5,629,354), oxime ethers and oxime esters (such as those derived from benzoin), α-hydroxy or α-amino-acetophenones, alkyltriarylborates, trihalogenomethylarylsulfones, benzoin ethers and esters, peroxides (such as benzoyl peroxide), hydroperoxides (such as cumyl hydroperoxide), azo compounds (such as azo bisisobutyronitrile) as described, for example, in U.S. Patent No. 4,565,769, borate and organoborate salts such as those described in U.S. Patent No. 6,562,543, and onium salts. Other known initiator composition components are described, for example, in U.S Patent Publ. No. 2003/0064318.

Particularly useful initiator composition components for UV and visible light sensitive photoresponsive compositions include hexaarylbiimidazoles (also known as triarylimidazolyl dimers) such as, for example, 2,2'-bis(2-chlorophenyl)-4,4',5,5'-tetraphenylbiimidazole and 2,2'-bis(o-chlorophenyl-4,4',5,5'-tetra(m-methoxyphenyl)biimidazole. The triazines noted below can be used with exposure to imaging radiation at about any wavelength including UV and visible radiation exposure. Other UV-photoresponsive free-radical-generating compounds include but are not limited to, trichloromethyl triazines as described, for example, in U.S. Patent No. 4,997,745 and diaryliodonium salts.

Co-initiators can also be used. Suitable co-initiators include metallocenes (such as titanocenes and ferrocenes), mono- and polycarboxylic acids such as anilino diacetic acid, haloalkyl triazines, thiols or mercaptans (such as mercaptotriazoles), borate salts, and photooxidants containing a heterocyclic nitrogen that is substituted by an alkoxy or acyloxy group, as described in U.S. Patent No. 5,942,372.

For IR-sensitive photoresponsive compositions, suitable initiator compositions comprise or consist essentially of an onium salt such as a sulfonium, oxysulfoxonium, oxysulfonium, sulfoxonium, ammonium, selenonium, arsonium, phosphonium, diazonium, or halonium salt. Preferred onium salts are iodonium salts, particularly iodonium borate salts. Further details of useful onium salts, including representative examples, are provided in U.S. Patent Publ. No. 2002/0068241, WO 2004/101280 (Munnelly et al.), and U.S. Patent Nos. 5,086,086, 5,965,319, and 6,051,366. For example, suitable phosphonium salts include positively charged hypervalent phosphorus atoms with four organic substituents. Suitable sulfonium salts such as triphenylsulfonium salts include a positively charged hypervalent sulfur with three organic substituents. Suitable diazonium salts possess a positively charged azo group (that is, -N=N⁺). Suitable ammonium salts include a positively charged nitrogen atom such as substituted quaternary ammonium salts with four organic substituents, and quaternary nitrogen heterocyclic rings such as N-alkoxypyridinium salts. Suitable halonium salts include a positively charged hypervalent halogen atom with two organic substituents. The onium salts generally include a suitable number of negatively charged counterions such as halides, hexafluorophosphate, thiosulfate, hexafluoroantimonate, tetrafluoroborate, sulfonates, hydroxide, perchlorate, n-butyltriphenyl borate, tetraphenyl borate, and others readily apparent to one skilled in the art.

In one embodiment, the onium salt has a positively-charged iodonium (4-methylphenyl)[4-(2-methylpropyl)phenyl] moiety and a suitable negatively charged counterion. A representative example of such an iodonium salt is available as IRGACURE 250 from Ciba Specialty Chemicals (Tarrytown, N.Y.) that is (4-methylphenyl)[4-(2-methylpropyl)phenyl]iodonium hexafluorophosphate and is supplied in a 75% propylene carbonate solution.

Useful boron components include organic boron salts having an organic boron anion (such as any of those described in U.S. Patent No. 6,569,603) that is paired with a suitable cation such as an alkali metal ion, an onium, or a cationic sensitizing dye. Useful onium cations include ammonium, sulfonium, phosphonium, iodonium, and diazonium cations. They may be used alone or in combination with various co-initiators such as heterocyclic mercapto compounds including mercaptotriazoles, mercaptobenzimidazoles, mercaptobenzoxazoles, mercaptobenzothiazoles, mercaptobenzoxadiazoles, mercaptotetrazoles, such as those described in U.S. Patent No. 6,884,568 in amounts of at least 0.5 and up to and including 10 wt% based on the total solids of the photoresponsive composition.

Some initiator compositions include one or more azine compounds as described, for example, in U.S. Patent No. 6,936,384. These compounds are organic heterocyclic compounds containing a 6-membered ring formed from carbon and nitrogen atoms. Azine compounds include heterocyclic groups such as pyridine, diazine, and triazine groups, as well as polycyclic compounds having a pyridine, diazine, or triazine substituent fused to one or more aromatic rings such as carbocyclic aromatic rings. Thus, the azine compounds include, for example, compounds having a quinoline, isoquinoline, benzodiazine, or naphthodiazine substituent. Both monocyclic and polycyclic azine compounds are useful.

Useful azine compounds include triazine compounds that have a 6-membered ring containing 3 carbon atoms and 3 nitrogen atoms such as those described in U.S. Patent Nos. 6,309,792, 6,010,824, 5,885,746, 5,496,903, and 5,219,709. The azinium form of azine compounds can also be used if desired. In azinium compounds, a quaternizing substituent of a nitrogen atom in the azine ring is capable of being released as a free radical. The alkoxy substituent that quaternizes a ring nitrogen atom of the azinium nucleus can be selected from among a variety of alkoxy substituents.

Halomethyl-substituted triazines, such as trihalomethyl triazines, are particularly useful in the initiator composition. Representative compounds of this type include but are not limited to, 1,3,5-triazine derivatives - such as those having 1 to 3 -CX₃ groups, where each X independently represents a chlorine or bromine atom - including polyhalomethyl-substituted triazines and other triazines, such as 2,4-trichloromethyl-6-methoxyphenyl triazine, 2-phenyl-4,6-bis(trichloromethyl)-s-triazine,2,4,6-tris(trichloromethyl)-s-triazine, 2-methyl-4,6-bis(trichloromethyl)-s-triazine, 2-(styryl-4,6-bis(trichloromethyl)-s-triazine, 2-(p-methoxystyryl)-4,6-bis(trichloromethyl)-s-triazine, 2-(4-methoxy-naphtho-1-yl)-4,6-bis(trichloromethyl)-s-triazine, 2-(4-ethoxynaphtho-1-yl)-4,6-bis(trichloromethyl)-s-triazine, and 2-(4-(2-ethoxyethyl)-naphtho-1-yl)-4,6-bis(trichloromethyl)-s-triazine], 2-(4-methylthiophenyl)-4,6-bis(trichloromethyl)-2-triazine, 2-(4-chlorophenyl-4,6-bis(trichloromethyl)-2-triazine, 2,4,6-tri(trichloromethyl)-2-triazine, and 2,4,6-tri(tribromomethyl)-2-triazine. The azine compounds and particularly the triazine compounds may be used alone or in combination with one or more co-initiators such as titanocenes, mono- and polycarboxylic acids, hexaarylbisimidazoles, as described, for example, in U.S. Patent No. 4,997,745.

In some embodiments, the photoresponsive composition also includes a mercaptan derivative such as a mercaptotriazole such as 3-mercapto-1,2,4-triazole, 4-methyl-3-mercapto-1,2,4-triazole, 5-mercapto-1-phenyl-1,2,4-triazole, 4-amino-3-mercapto-1,2,4,-triazole, 3-mercapto-1,5-diphenyl-1,2,4-triazole, and 5-(p-aminophenyl)-3-mercapto-1,2,4-triazole. Various mercaptobenzimidazoles, mercaptobenzothiazoles, and mercaptobenzoxazoles may also be present.

Thus, several initiator/co-initiator combinations can be used in various embodiments of the present invention, including:
a) a triazine in combination with a co-initiator that is an N-aryl, S-aryl, or O-aryl polycarboxylic acids with at least 2 carboxy groups of which at least one is bonded to the nitrogen, oxygen, or sulfur atom of the aryl moiety (such as aniline diacetic acid and derivatives thereof),
b) a triazine in combination with a co-initiator that is a mercaptan derivative as described above,
c) an iodonium salt (such as an iodonium borate) in combination with a co-initiator that is a metallocene (for exampl,e a titanocene or ferrocene) as described, for example, in U.S. Patent No. 6,936,384, and
d) an iodonium salt (such as an iodonium borate) in combination with a co-initiator that is a mercaptotriazole.

The initiator compositions may comprise or consist essentially of one or more diaryliodonium borate compounds, each of which is represented by the following structure: 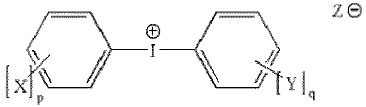 where X and Y are independently halo groups (for example, fluoro, chloro, or bromo), substituted or unsubstituted alkyl groups having 1 to 20 carbon atoms (for example, methyl, chloromethyl, ethyl, 2-methoxyethyl, n-propyl, isopropyl, isobutyl, n-butyl, t-butyl, all branched and linear pentyl groups, 1 -ethylpentyl, 4-methylpentyl, all hexyl isomers, all octyl isomers, benzyl, 4-methoxybenzyl, p-methylbenzyl, all dodecyl isomers, all icosyl isomers, and substituted or unsubstituted mono-and poly-, branched and linear haloalkyls), substituted or unsubstituted alkyloxy having 1 to 20 carbon atoms (for example, substituted or unsubstituted methoxy, ethoxy, iso-propoxy, t-butoxy, (2-hydroxytetradecyl)oxy, and various other linear and branched alkyleneoxyalkoxy groups), substituted or unsubstituted aryl groups having 6 or 10 carbon atoms in the carbocyclic aromatic ring (such as substituted or unsubstituted phenyl and naphthyl groups including mono- and polyhalophenyl and naphthyl groups), or substituted or unsubstituted cycloalkyl groups having 3 to 8 carbon atoms in the ring structure (for example, substituted or unsubstituted cyclopropyl, cyclopentyl, cyclohexyl, 4-methylcyclohexyl, and cyclooctyl groups). X and Y may be independently substituted or unsubstituted alkyl groups having 1 to 8 carbon atoms, alkyloxy groups having 1 to 8 carbon atoms, or cycloalkyl groups having 5 or 6 carbon atoms in the ring; for example, X and Y may be independently substituted or unsubstituted alkyl groups having 3 to 6 carbon atoms (and particularly branched alkyl groups having 3 to 6 carbon atoms). Thus, X and Y can be the same or different groups, the various X groups can be the same or different groups, and the various Y groups can be the same or different groups. Both "symmetric" and "asymmetric" diaryliodonium borate compounds are contemplated by this invention but the "symmetric" compounds are preferred (that is, they have the same groups on both phenyl rings). In addition, two or more adjacent X or Y groups can be combined to form a fused carbocyclic or heterocyclic ring with the respective phenyl groups. The X and Y groups can be in any position on the phenyl rings but preferably they are at the 2- or 4-positions, and more preferably at the 4-position, on either or both phenyl rings.

Z⁻ is an organic borate anion represented by the following structure: 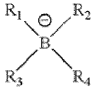 where R₁, R₂, R₃, and R₄ are independently substituted or unsubstituted alkyl groups having 1 to 12 carbon atoms (such as methyl, ethyl, n-propyl, iso-propyl, n-butyl, isobutyl, t-butyl, all pentyl isomers, 2-methylpentyl, all hexyl isomers, 2-ethylhexyl, all octyl isomers, 2,4,4-trimethylpentyl, all nonyl isomers, all decyl isomers, all undecyl isomers, all dodecyl isomers, methoxymethyl, and benzyl) other than fluoroalkyl groups, substituted or unsubstituted carbocyclic aryl groups having 6 to 10 carbon atoms in the aromatic ring (such as phenyl, p-methylphenyl, 2,4-methoxyphenyl, naphthyl, and pentafluorophenyl groups), substituted or unsubstituted alkenyl groups having 2 to 12 carbon atoms (such as ethenyl, 2-methylethenyl, allyl, vinylbenzyl, acryloyl, and crotonotyl groups), substituted or unsubstituted alkynyl groups having 2 to 12 carbon atoms (such as ethynyl, 2-methylethynyl, and 2,3-propynyl groups), substituted or unsubstituted cycloalkyl groups having 3 to 8 carbon atoms in the ring structure (such as cyclopropyl, cyclopentyl, cyclohexyl, 4-methylcyclohexyl, and cyclooctyl groups), or substituted or unsubstituted heterocyclyl groups having 5 to 10 carbon, oxygen, sulfur, and nitrogen atoms (including both aromatic and non-aromatic groups, such as substituted or unsubstituted pyridyl, pyrimidyl, furanyl, pyrrolyl, imidazolyl, triazolyl, tetrazoylyl, indolyl, quinolinyl, oxadiazolyl, and benzoxazolyl groups). Alternatively, two or more of R₁, R₂, R₃, and R₄ can be joined together to form a heterocyclic ring with the boron atom, such rings having up to 7 carbon, nitrogen, oxygen, or nitrogen atoms.

R₁, R₂, R₃, and R₄ may be independently substituted or unsubstituted alkyl or aryl groups, and at least 3 of R₁, R₂, R₃, and R₄ may be the same or different substituted or unsubstituted aryl groups (such as substituted or unsubstituted phenyl groups). In some embodiments, all of R₁, R₂, R₃, and R₄ are the same or different substituted or unsubstituted aryl groups, e.g., all of the groups may be the same substituted or unsubstituted phenyl group. Z⁻ may be a tetraphenyl borate where the phenyl groups are substituted or unsubstituted.

Representative iodonium borate compounds useful in this invention include but are not limited to, 4-octyloxyphenyl phenyliodonium tetraphenylborate, [4-[(2-hydroxytetradecyl)-oxy]phenyl]phenyliodonium tetraphenylborate, bis(4-t-butylphenyl)iodonium tetraphenylborate, 4-methylphenyl-4'-hexylphenyliodonium tetraphenylborate, 4-methylphenyl-4'-cyclohexylphenyliodonium tetraphenylborate, bis(t-butylphenyl)iodonium tetrakis(pentafluorophenyl)borate, 4-hexylphenyl-phenyliodonium tetraphenylborate, 4-methylphenyl-4'-cyclohexylphenyliodonium n-butyltriphenylborate, 4-cyclohexylphenyl-phenyliodonium tetraphenylborate, 2-methyl-4-t-butylphenyl-4'-methylphenyliodonium tetraphenylborate, 4-methylphenyl-4'-pentylphenyliodonium tetrakis[3,5-bis(trifluoromethyl)phenyl]-borate, 4-methoxyphenyl-4'-cyclohexylphenyliodonium tetrakis(pentafluorophenyl)borate, 4-methylphenyl-4'-dodecylphenyliodonium tetrakis(4-fluorophenyl)borate, bis(dodecylphenyl)iodonium tetrakis(pentafluorophenyl)borate, and bis(4-t-butylphenyl)iodonium tetrakis(1-imidazolyl)borate. Preferred compounds include bis(4-t-butylphenyl)iodonium tetraphenylborate, 4-methylphenyl-4'-hexylphenyliodonium tetraphenylborate, 2-methyl-4-t-butylphenyl-4'-methylphenyliodonium tetraphenylborate, and 4-methylphenyl-4'-cyclohexylphenyliodonium tetraphenylborate. Mixtures of two or more of these compounds can also be used in the initiator composition. The diaryliodonium borate compounds can be prepared, in general, by reacting an aryl iodide with a substituted or unsubstituted arene, followed by an ion exchange with a borate anion. Details of various preparatory methods are described in U.S. Patent No. 6,306,555, and references cited therein, and in Crivello, J. Polymer Sci., Part A: Polymer Chemistry, 37, 4241-4254 (1999).

The initiator composition including one or more initiator compounds is generally present in the photoresponsive composition in an amount of from 0.5% to 30%, based on the total solids of the photoresponsive composition or the dry weight of the coated layer. The initiator composition may, for example, be present in an amount of from 2% to 20 wt%. In various embodiments, one or more diaryliodonium borate compounds generally comprise from 10 to 100% of the initiator composition.

Polymeric binders other than the poly(urethane-acrylic) hybrids described above can be utilized. Such polymeric binders can be any of those known in the art for use in negative-working photoresponsive compositions. These polymeric binders generally have a molecular weight of from 2,000 to 1,000,000 and preferably from 10,000 to 200,000. The acid value (mg KOH/g) of the polymeric binder is generally from 20 to 400 as determined using known methods. Such polymeric binders can be particulate or film-forming in nature. Furthermore, in some embodiments, the polymeric binder takes part in the polymerization reaction; for example, the polymer binder may contain ethylenic unsaturation.

Examples of polymeric binders include, but are not limited to, those derived at least in part from one or more monomers having pendant carboxyl groups such as (meth)acrylic acids, (meth)acrylates, (meth)acrylamides, (meth)acrylonitriles, poly(alkylene glycols), poly(alkylene glycol)(meth)acrylates, vinyl acetals, styrene and substituted styrenes, N-substituted cyclic imides or maleic anhydrides, such as those described in EP 1,182,033 and U.S. Patent Nos. 6,309,792, 6,352,812, 6,569,603, and 6,893,797. Phenolic resins may also be used. Also useful are the vinyl carbazole polymers having pendant N-carbazole moieties including those described in U.S. Patent No. 4,774,163 and polymers having pendant vinyl groups including those described in U.S. Patent Nos. 6,899,994 and 4,511,645, and EP 1,182,033. In some embodiments, polymers derived from one or more monomers with pendant carboxy groups, (meth)acrylates, styrene and styrene derivatives, vinyl acetal, N-substituted cyclic imides, maleic anhydride, vinyl carbazoles, monomers with multiple vinyl groups, (meth)acrylonitriles, (meth)acrylamides, poly(alkylene glycols), poly(alkylene glycol) (meth)acrylates, and N-substituted (meth)acrylamides are employed as polymeric binders.

Other useful polymeric binders are dispersible or soluble in water or water/solvent mixtures such as fountain solutions. Such polymeric binders include polymeric emulsions, dispersions, or graft polymers having pendant poly(alkyleneoxide) side chains that can augment the plate's amenability to on-press development by subjection to fountain solution. Such polymeric binders are described, for example, in U.S. Patent Nos. 6,582,882 and 6,899,994. Other useful polymeric binders have hydrophobic backbones and comprise both of the following a) and b) recurring units, or the b) recurring units alone:
a) recurring units having pendant cyano groups attached directly to the hydrophobic backbone, and
b) recurring units having pendant groups comprising poly(alkylene oxide) segments.

These polymeric binders may comprise poly(alkylene oxide) segments and preferably poly(ethylene oxide) segments. They can, for example, be graft copolymers having a main chain polymer and poly(alkylene oxide) pendant side chains or segments or block copolymers having blocks of (alkylene oxide)-containing recurring units and non(alkylene oxide)-containing recurring units. Both graft and block copolymers can additionally have pendant cyano groups attached directly to the hydrophobic backbone. The alkylene oxide constitutional units are generally C₁ to C₆ alkylene oxide groups, and more typically C₁ to C₃ alkylene oxide groups. The alkylene portions can be linear or branched or substituted versions thereof.

In some embodiments, the polymeric binders contain only recurring units comprising poly(alkylene oxide) segments, but in other embodiments, the polymeric binders comprise recurring units comprising the poly(alkylene oxide) segments as well as recurring units having pendant cyano groups attached directly to the hydrophobic backbone. By way of example only, such recurring units can comprise pendant groups comprising cyano, cyano-substituted alkylene groups, or cyano-terminated alkylene groups. Recurring units can also be derived from ethylenically unsaturated polymerizable monomers such as acrylonitrile, methacrylonitrile, methyl cyanoacrylate, ethyl cyanoacrylate, or a combination thereof. However, cyano groups can be introduced into the polymer by other conventional means. Examples of such cyano-containing polymeric binders are described, for example, in U.S. Patent Publ. No. 2005/003285. By way of example, suitable polymeric binders can be formed by polymerization of a combination or mixture of suitable ethylenically unsaturated polymerizable monomers or macromers, such as:
A) acrylonitrile, methacrylonitrile, or a combination thereof,
B) poly(alkylene oxide) esters of acrylic acid or methacrylic acid, such as poly(ethylene glycol) methyl ether acrylate, poly(ethylene glycol) methyl ether methacrylate, or a combination thereof, and
C) optionally, monomers such as acrylic acid, methacrylic acid, styrene, hydroxystyrene, acrylate esters, methacrylate esters, acrylamide, methacrylamide, or a combination of such monomers.

The amount of the poly(alkylene oxide) segments in these polymeric binders may be from 0.5 to 60 wt%, e.g., from 2 to 50 wt%, from 5 to 40 wt%, or from 5 to 20 wt%. The amount of (alkylene oxide) segments in the block copolymers is generally from 5 to 60 wt%, e.g., from 10 to 50 wt%, or from 10 to 30 wt%. It is also possible that the polymeric binders having poly(alkylene oxide) side chains are present in the form of discrete particles.

Still other polymeric binders are represented by the following structure:

-(A)ₓ-(B)_{y}-(C)_{z}-

where A represents recurring units comprising a pendant -C(=O)O-CH₂CH=CH₂ group, B represents recurring units comprising pendant cyano groups, and C represents recurring units other than those represented by A and B and optionally including recurring units having pendant carboxy groups (for example, recurring units in which the carboxy groups are not converted to -C(=O)O-CH₂CH=CH₂ groups). B may represent recurring units derived from (meth)acrylonitrile, and C represents recurring units derived from one or more (meth)acrylic acid esters, (meth)acrylamides, vinyl carbazole, styrene and styrenic derivatives thereof, N-substituted maleimides, (meth)acrylic acid, maleic anhydride, vinyl acetate, vinyl ketones (such as vinyl methyl ketone), vinyl pyridines, N-vinyl pyrrolidones, 1 -vinylimidazole, and vinyl polyalkylsilanes (such as vinyl trimethylsilane). For example, B may represent recurring units derived from acrylonitrile, with C derived from one or more of methacrylic acid, acrylic acid, vinyl carbazole, methyl methacrylate, 2-hydroxyethyl methacrylate, styrene, and N-phenylmaleimide.

The polymeric binders represented by the above structure are generally present in the photoresponsive composition (and imageable layer) in an amount of from 10 to 70 wt%, based on the total composition or layer solids. In some embodiments, the amount is from 20 to 50 wt%. The polymeric binders described above can be present in an amount of from 1.5 to 75%, e.g., from 1.5 to 40%, based on the total solids content of the photoresponsive composition or the dry weight of the imageable layer prepared there from.

The photoresponsive compositions also include a radiation-absorbing compound (sometimes called a "sensitizer") that is sensitive to radiation at a desired wavelength. These compounds absorb the radiation and facilitate polymerization during imaging. The radiation-absorbing compounds can be sensitive to radiation having a wavelength of from 150 to 1400 nm. The compounds sensitive to UV and visible radiation generally have a λₘₐₓ of from 150 to 600 nm, e.g., from 200 to 550 nm.

In some embodiments, the photoresponsive composition contains a UV sensitizer where the free-radical generating compound is UV radiation sensitive (that is, at least 250 nm and up to and including 450 nm), thereby facilitating photopolymerization. Typical UV photoresponsive free-radical generating compounds are described above. In some preferred embodiments, the radiation sensitive compositions are sensitized to "violet" radiation in the range of at least 375 nm and up to and including 450 nm. Useful sensitizers for such compositions include certain pyrilium and thiopyrilium dyes and 3-ketocoumarins (particularly in combination with a polycarboxylic acid free radical generating compound, such as anilino-N,N-diacetic acid).

Sensitizers that absorb in the visible region of the electromagnetic spectrum (that is, at least 400 nm and up to and including 650 nm) can also be used. Examples of such sensitizers are well known in the art and include the compounds described in cols. 17-22 of U.S. Patent No. 6,569,603. Other useful visible and UV-sensitive sensitizing compositions include a cyanine dye, diaryliodonium salt, and a co-initiator (as described above) as disclosed in U.S. Patent No. 5,368,990. Other useful sensitizers for the violet/visible region of sensitization are the 2,4,5-triaryloxazole derivatives as described in WO 2004/074930. These compounds can be used alone or with a co-initiator as described above, and especially with the 1,3,5-triazines described above or with thiol compounds. Useful 2,4,5-triaryloxazole derivatives can be represented by the Structure G-(Ar₁)₃ wherein Ar₁ is the same or different, substituted or unsubstituted carbocyclic aryl group having 6 to 12 carbon atoms in the ring, and G is a furan, oxazole, or oxadiazole ring. The Ar₁ groups can be substituted with one or more halo, substituted or unsubstituted alkyl, substituted or unsubstituted cycloalkyl, substituted or unsubstituted aryl, amino (primary, secondary, or tertiary), or substituted or unsubstituted alkoxy or aryloxy groups. Thus, the aryl groups can be substituted with one or more R'₁ through R'₃ groups, respectively, that are independently hydrogen or a substituted or unsubstituted alkyl group having from 1 to 20 carbon atoms (such as methyl, ethyl, iso-propyl, n-hexyl, benzyl, and methoxymethyl groups) substituted or unsubstituted carbocyclic aryl group having 6 to 10 carbon atoms in the ring (such as phenyl, naphthyl, 4-methoxyphenyl, and 3-methylphenyl groups), substituted or unsubstituted cycloalkyl group having 5 to 10 carbon atoms in the ring, a-N(R'₄)(R'₅) group, or a -OR'₆ group where R'₄through R'₆ independently represent substituted or unsubstituted alkyl or aryl groups as defined above. At least one of R'₁ through R'₃ may be an -N(R'₄)(R'₅) group where R'₄ and R'₅ are the same or different alkyl groups. Substituents for each Ar₁ group include the same or different primary, secondary, and tertiary amines, e.g., the same dialkylamines.

Still another class of useful violet/visible radiation sensitizers includes compounds represented by the structure Ar₁-G-Ar₂ where Ar₁ and Ar₂ are the same or different substituted or unsubstituted aryl groups having 6 to 12 carbon atoms in the ring, or Ar₂ can be an arylene-G-Ar₁ or arylene-G-Ar₂ group, and G is a furan, ozazole, or oxadiazole ring. Ar₁ is the same as defined above, and Ar₂ can be the same or different aryl group as Ar₁. "Arylene" can be any of the aryl groups defined for Ar₁ but with a hydrogen atom removed to render them divalent in nature.

Additional useful "violet"-visible radiation sensitizers are described in WO 2004/074929. These compounds comprise the same or different aromatic heterocyclic groups connected with a spacer moiety that comprises at least one carbon-carbon double bond that is conjugated to the aromatic heterocyclic groups, and are represented in more detail by Formula (I) of the noted publication.

In the commercial applications of primary interest, the radiation-absorbing compounds are sensitive to IR and near-IR radiation, that is, a wavelength of from 600 to 1400 nm, e.g., from 700 to 1200 nm. Such near-IR absorbers include carbon blacks and other IR-absorbing pigments and various IR-sensitive dyes ("IR dyes"), which are preferred. Examples of suitable IR dyes include but are not limited to, azo dyes, squarilium dyes, croconate dyes, triarylamine dyes, thiazolium dyes, indolium dyes, oxonol dyes, oxaxolium dyes, cyanine dyes, merocyanine dyes, phthalocyanine dyes, indocyanine dyes, indotricarbocyanine dyes, oxatricarbocyanine dyes, thiocyanine dyes, thiatricarbocyanine dyes, merocyanine dyes, cryptocyanine dyes, naphthalocyanine dyes, polyaniline dyes, polypyrrole dyes, polythiophene dyes, chalcogenopyryloarylidene and bi(chalcogenopyrylo)polymethine dyes, oxyindolizine dyes, pyrylium dyes, pyrazoline azo dyes, oxazine dyes, naphthoquinone dyes, anthraquinone dyes, quinoneimine dyes, methine dyes, arylmethine dyes, squarine dyes, oxazole dyes, croconine dyes, porphyrin dyes, and any substituted or ionic form of the preceding dye classes. Suitable dyes are also described in U.S. Patent Nos. 5,208,135, 6,569,603, and 6,787,281, and EP Publication 1,182,033. A general description of one class of suitable cyanine dyes is shown by the formula in paragraph [0026] of WO 2004/101280. In addition to low-molecular-weight IR-absorbing dyes, IR dye moieties bonded to polymers can be used as well. Moreover, IR dye cations can be used as well, that is, the cation is the IR-absorbing portion of the dye salt that ionically interacts with a polymer comprising carboxy, sulfo, phospho, or phosphono groups in the side chains.

Near-IR-absorbing cyanine dyes are also useful and are described, for example, in U.S. Patent Nos. 6,309,792, 6,264,920, 6,153,356, and 5,496,903. Suitable dyes may be formed using conventional methods and starting materials or obtained from various commercial sources including American Dye Source (Baie D'Urfe, Quebec, Canada) and FEW Chemicals (Germany). Other useful dyes for near infrared diode laser beams are described, for example, in U.S Pat. No. 4,973,572.

Useful IR-absorbing compounds include carbon blacks, e.g., carbon blacks that are surface-functionalized with solubilizing groups are well known in the art. Carbon blacks that are grafted to hydrophilic, nonionic polymers, such as FX-GE-003 (manufactured by Nippon Shokubai), or which are surface-functionalized with anionic groups, such as CAB-O-JET 200 or CAB-O-JET® 300 (manufactured by the Cabot Corporation) are also useful.

The radiation absorber is present in sufficient amounts to sensitize the coating to laser radiation produced by a laser. For example, the radiation-absorbing compound can be present in the photoresponsive composition in an amount generally of from 1% to 20% and preferably from 1.5 to 10%, based on total solids in the composition that also corresponds to the total dry weight of the imageable layer. Alternatively, the amount can be defined by an absorbance in the range of from 0.05 to 3, and preferably of from 0.1 to 1.5, in the dry film as measured by reflectance UV-visible spectrophotometry. The particular amount needed for this purpose would be readily apparent to one skilled in the art, depending upon the specific compound used.

Printing members are formed by suitable application of a photoresponsive composition as described above to substrate 105 to form an imageable layer. Substrate 105 can be treated or coated in various ways as described above prior to application of the photoresponsive composition. If substrate 105 has been treated to provide an "interlayer" for improved adhesion or hydrophilicity, the applied photoresponsive composition is generally considered the "top" or outermost layer.

While there is usually no need to apply what is conventionally known as an overcoat (such as an oxygen impermeable topcoat) to the imageable layer(s) as described in WO 99/06890, it can be used if desired. Such overcoat layers or topcoats can comprise one or more water-soluble polymers such as poly(vinyl alcohol), poly(vinyl pyrrolidone), poly(vinyl imidazole), and water-based acrylic copolymers. Alternatively or in addition, poly(urethane-acrylic) hybrid particles (such as the HYBRJDUR material from Air Products and Chemicals) can be used; these hybrid materials are described, for example, in U.S. Patent No. 7,452,638 at col. 10, line 11 to line 23, and line 60 to col. 11, line 5. Overcoat coat weights typically range from 0.1 to 1.0 g/m², and preferably from 0.1 to 0.4 g/m².

The photoresponsive composition can be applied to substrate 105 as a solution or dispersion in a coating liquid using any suitable equipment and procedure, such as spin coating, knife coating, gravure coating, die coating, slot coating, bar coating, wire rod coating, roller coating, or extrusion hopper coating. The composition can also be applied by spraying onto a suitable support.

Illustrative of such manufacturing methods is mixing the polymerizable component, initiator composition, radiation-absorbing compound, polymeric binder(s), and any other components of the photoresponsive composition in a suitable organic solvent (such as methyl ethyl ketone (2-butanone), methanol, ethanol, 1-methoxy-2-propanol, iso-propyl alcohol, acetone, γ-butyrolactone, n-propanol, tetrahydrofuran, and others readily known in the art, as well as mixtures thereof), applying the resulting solution to a substrate, and removing the solvent(s) by evaporation under suitable drying conditions. Representative coating solvents and imageable layer formulations are described in the examples below. After proper drying, the coating weight of the imageable layer is generally from 0.1 to 5 g/m², preferably from 0.5 to 3.5 g/m², and more preferably from 0.5 to 2 g/m².

The imageable elements have any useful form including but not limited to, printing plate precursors, printing cylinders, printing sleeves and printing tapes (including flexible printing webs). The imageable members are printing plate precursors that can be of any useful size and shape (for example, square or rectangular) having the requisite imageable layer disposed on a suitable substrate. Printing cylinders and sleeves are known as rotary printing members having the substrate and imageable layer in a cylindrical form. Hollow or solid metal cores can be used as substrates for printing sleeves.

### EXAMPLES

### Examples 1, C2, C3 and C4

A series of coatings (referred to as "image" layers) were prepared using the basic formulation listed in Table 1. Component descriptions and sources follow.

| Table 1 | |
|---|---|
| Image Layer | |
| **Component** | **PPH** |
| Dowanol PM | 92.67 |
| Dianal BR-113 | 1.27 |
| Sartomer SR399 | 2.47 |
| Sartomer SR9053 | 1.06 |
| Irgacure 250 | 1.02 |
| Tetraphenylborate | 0.15 |
| Few S0507 Dye | 0.14 |
| BYK 378 | 0.04 |
| **Urethane Acrylic Oligomer** | **1.18** |

| ***Component*** | ***Description*** | ***Manufacturer*** |
|---|---|---|
| Dowanol PM | Glycol Ether Solvent | Dow Chemical Company |
| Dianal BR-113 | Acrylic Resin | Dianal America, Inc |
| | | Pasadena, TX |
| Sartomer SR399 | Dipentaerythritol Pentaacrylate Monomer | Sartomer Americas |
| | | Exton, PA |
| Sartomer SR9053 | Trifunctional Acid Ester | Sartomer Americas |
| | | Exton, PA |
| Irgacure 250 | Iodonium Initiator | BASF Florham |
| | | Park, NJ |
| Sodium Tetraphenyl Borate | Co-initiator | Sigma Aldrich |
| | | St. Louis, MO |
| S0507 Dye | Cyanine Dye (IR) | Few Chemicals |
| | | Germany |
| BYK 378 | Surfactant | BYK Chemie, Inc |
| Bomar XR-9416 | Water dilutable urethane acrylate oligomer | Dymax |
| | | Torrington, CT |
| Ebecryl 220 | Aromatic urethane acrylate oligomer | Allnex |
| | | Belgium |
| Ebecryl 830 | Alliphatic urethane acrylate oligomer | Allnex |
| | | Belgium |
| CN975 | Aromatic urethane acrylate oligomer | Sartomer Americas |
| | | Exton, PA |

Several different urethane acrylic oligomers were substituted into the formulation at a level of 1.18 pph:

| | | |
|---|---|---|
| Example 1 | Sample A: | Bomar XR-9416 - a water-reducible aliphatic urethane acrylic oligomer (Dymax Corp) |
| Example C2 | Sample B: | Ebecryl 220 - an aromatic urethane acrylic oligomer (Allnex) |
| Example C3 | Sample C: | Ebecryl 830 - an aliphatic urethane acrylic oligomer (Allnex) |
| Example C4 | Sample D: | CN975 - an aromatic urethane acrylic oligomer (Sartomer) |

Each coating was applied to an EC-grained, anodized and post-treated aluminum substrate using a wire-wound coating rod, resulting in an approximate dry coating weight of .75 g/m².

All coated plates were exposed (imagewise) on a PRESSTEK DIMENSION PRO 800 at 184 mJ/cm². Plates were then individually mounted on a Heidelberg GTO press (with a KOMPAC dampening system). Prior to inking, each plate was wetted with fountain solution for 25 seconds (to remove the non-imaged coating). Press sheets were examined and compared post-test. The number of impressions needed to produce a clean background was noted for each variant, along with the level of acceptable dot reproduction.

**Results:**

| **Example** | **Variation** | **Sheets to Clean Background** | **Lowest % Dot Printed at Each Impression** | | | |
|---|---|---|---|---|---|---|
| | | | **25** | **200** | **500** | **1000** |
| 1 | A | <25 | .5% | .5% | .5% | .5% |
| C2 | B | 500 | NA | NA | 1% | 1% |
| C3 | C | 200 | NA | 1% | ∼1% | ∼1% |
| C4 | D | 300 | NA | 1% | ∼1% | ∼1% |

Example 1, which contained the water-dilutable urethane oligomer, rolled up very quickly, producing clean/acceptable printed sheets within 25 impressions. All other variations took from 8 to 20 times longer (200-500 impressions to clean). Resolution (print quality) was also improved in Example 1, relative to the comparative examples. This preferred variation was able to print .5% dots. The lowest level of dots printed on all other variations was 1%. Examples C3 and C4 also showed signs of dot wear after just 500 impressions.

### Examples 5 and C6

In order to improve development and/or plate durability (run length on press), an aqueous topcoat can be applied (on top of the image layer) to create a two-layer design. A representative topcoat formulation is set forth in Table 2. Component descriptions and sources follow.

| Table 2 | |
|---|---|
| Topcoat Layer | |
| **Component** | **PPH** |
| Deionized Water | 94.08 |
| Neocryl A-1125 | 5.12 |
| Selvol 125 | 0.60 |
| Triton X-100 | 0.10 |
| BYK333 | 0.10 |

| Component | Description | Manufacturer |
|---|---|---|
| Neocryl A-1125 | Aqueous acrylic copolymer emulsion | DSM |
| | | Wilmington, MA |
| Selvol 125 | Polyvinyl alcohol resin | Sekisui |
| | | Dallas, TX |
| Triton X-100 | Surfactant | Dow Chemical Company |
| BYK 333 | Surfactant | BYK Chemie, Inc |

Two different 2-layer designs were prepared to further demonstrate the benefits of embodiments of the present invention. After coating, single-layer image layers A and D (Examples 5 and C6, above), an aqueous topcoat (Table 2) was applied to each plate. A formed coating rod was utilized for this application, and a dry coating weight of approximately .20 g/m² was targeted. With image layer A (containing the water-reducible oligomer), the aqueous topcoat wetted out the surface well, coating very evenly. The topcoat did not coat as well on top of image layer D. De-wets were noted, indicating that an increased level of surfactant would be needed in order to get the aqueous topcoat to wet out more evenly.

Plates were imaged on the DIMENSION PRO 800 (at 184 mJ), then individually mounted on the GTO for press testing.

**Results:**

| **Example** | **Variation** | **Sheets to Clean Background** | **Lowest % Dot Printed at Each Impression** | | | |
|---|---|---|---|---|---|---|
| | | | **25** | **200** | **500** | **1000** |
| 5 | A + Topcoat | <25 | .5% | .5% | .5% | .5% |
| C6 | D + Topcoat | 1000 | NA | NA | 1% | 1% |

Example 5 (variation A, containing the BOMAR XR-9416 in the image layer) rolled up very quickly, producing acceptable prints within 25 impressions. (This represented the same result as with the single-layer design utilizing this same oligomer.) Example C6, containing the CN975, took much longer to roll-up (1000 impressions), which was three times longer than its single-layer counterpart.

Although the present invention has been described with reference to specific details, it is not intended that such details should be regarded as limitations upon the scope of the invention, except as and to the extent that they are included in the accompanying claims.

## Claims

1. A method of preparing and printing with a lithographic printing member, the method comprising the steps of:
providing a lithographic printing member comprising:
(a) a hydrophilic first layer; and
(b) disposed over the first layer, an oleophilic imaging layer comprising (i) a component polymerizable by a free-radical polymerization mechanism, (ii) an initiator for generating, upon exposure to imaging radiation, free radicals to initiate polymerization of the polymerizable component, (iii) a near-IR absorber, and (iv) a polymeric binder, wherein the polymerizable component comprises a non-particulate, aliphatic urethane acrylic oligomer that is infinitely water-dilutable but not water-soluble;
exposing the printing member to infrared imaging radiation in an imagewise pattern to cause polymerization of the polymerizable component; and
printing with the printing member to remove only unexposed portions of the imaging layer without a developer during a make-ready phase, and thereafter to produce printed copy.

2. The method of claim 1, wherein a percentage by weight of acrylate groups in the urethane acrylic oligomer is in the range of 5 to 30 wt% or preferably in the range of 10 to 30 wt%.

3. The method of claim 1, wherein the polymerizable component consists essentially of the non-particulate, aliphatic urethane acrylic oligomer that is infinitely water-dilutable but not water-soluble.

4. The method of claim 1, wherein the aliphatic urethane acrylic oligomer constitutes more than 10 wt% but less than 40 wt% of the oleophilic imaging layer after drying, or preferably more than 10 wt% but less than 25 wt% of the oleophilic imaging layer after drying.

5. The method of claim 1, wherein the polymerizable component further comprises a non-urethane monomer.

6. The method of claim 5, wherein a weight ratio of the aliphatic urethane acrylic oligomer to the non-urethane monomer in the polymerizable component is in the range of 1:1.5 to 1:6, or preferably in the range of 1:1.5 to 1:4, or more preferably wherein the weight ratio is 1:3.

7. The method of claim 5, wherein the aliphatic urethane acrylic oligomer and the monomer collectively constitute 60 to 80 wt% of the oleophilic imaging layer after drying.

8. The method of any preceding claim , further comprising the step of applying the oleophilic imaging layer to the hydrophilic first layer using no water.

9. The method of any preceding claim, wherein the hydrophilic first layer is grained, anodized and post-anodically treated with sodium silicate.

10. A lithographic printing member comprising:
a hydrophilic first layer; and
disposed over the first layer, an oleophilic imaging layer comprising (i) a component polymerizable by a free-radical polymerization mechanism, (ii) an initiator responsive to imaging radiation for generating free radicals to initiate polymerization of the polymerizable component, (iii) a near-IR absorber, and (iv) a polymeric binder, wherein
the polymerizable component comprises a non-particulate, aliphatic urethane acrylic oligomer that is infinitely water-dilutable but not water-soluble.

11. The printing member of claim 10, wherein a percentage by weight of acrylate groups in the urethane acrylic oligomer is in the range of 5 to 30 wt%, or preferably in the range of 10 to 30 wt%.

12. The printing member of claim 10, wherein the polymerizable component consists essentially of the non-particulate, aliphatic urethane acrylic oligomer that is infinitely water-dilutable but not water-soluble.

13. The printing member of claim 10, wherein the aliphatic urethane acrylic oligomer constitutes more than 10 wt% but less than 40 wt% of the oleophilic imaging layer after drying, or preferably more than 10 wt% but less than 25 wt% of the oleophilic imaging layer after drying.

14. The printing member of claim 10, wherein the polymerizable component further comprises a non-urethane monomer, optionally wherein a weight ratio of the aliphatic urethane acrylic oligomer to the non-urethane monomer in the polymerizable component is in the range of 1:1.5 to 1:6, or preferably wherein the weight ratio is in the range of 1:1.5 to 1:4, or more preferably wherein the weight ratio is 1:3.

15. The printing member of claim 14, wherein the aliphatic urethane acrylic oligomer and the monomer collectively constitute 60 to 80 wt% of the oleophilic imaging layer after drying.

16. The printing member of claim 10, wherein the imaging layer has a dry coating weight less than 1 g/m².

17. The printing member of claim 10, wherein the initiator is an onium salt.

18. The printing member of claim 10, further comprising a water-soluble or water-dispersible topcoat over the oleophilic imaging layer, optionally wherein the topcoat has a dry coating weight no greater than 0.4 g/m² and optionally wherein the topcoat comprises a dispersion of particles of a poly(urethane-acrylic) hybrid.

## Patentansprüche

1. Verfahren zum Vorbereiten und Drucken mit einem lithographischen Druckelement, wobei das Verfahren die folgenden Schritte umfasst:
Bereitstellen eines lithographischen Druckelements, umfassend:
(a) eine erste hydrophile Schicht; und
(b) eine über die erste Schicht angeordnete oleophile Abbildungsschicht, umfassend (i) eine Komponente, welche durch einen Freiradikalpolymerisationsmechanismus polymerisierbar ist, (ii) einen Initiator zum Erzeugen, bei Belichten mit Abbildungsstrahlung, von freien Radikalen, um die Polymerisation der polymerisierbaren Komponente zu starten, (iii) einen Nah-IR-Absorber, und (iv) ein polymeres Bindungsmittel, wobei die polymerisierbare Komponente ein nicht partikelförmiges aliphatisches Urethan-Acryloligomer umfasst, welches unbegrenzt wasserverdünnbar aber nicht wasserlöslich ist;
Belichten des Druckelements mit Infrarot-Abbildungsstrahlung in einem bildförmigen Muster, um die Polymerisation der polymerisierbaren Komponente zu verursachen; und
Drucken mit dem Druckelement, um nur die unbelichteten Abschnitte der Abbildungsschicht ohne ein Entwicklungsmittel während einer Rüstphase zu entfernen und danach eine gedruckte Kopie herzustellen.

2. Verfahren nach Anspruch 1, wobei ein Gewichtsanteil von Acrylatgruppen in dem Urethan-Acryloligomer in dem Bereich zwischen 5 und 30 Gew.-% oder bevorzugt in dem Bereich zwischen 10 und 30 Gew.-% liegt.

3. Verfahren nach Anspruch 1, wobei die polymerisierbare Komponente im Wesentlichen aus dem nicht partikelförmigen aliphatischen Urethan-Acryloligomer besteht, welches unbegrenzt wasserverdünnbar aber nicht wasserlöslich ist.

4. Verfahren nach Anspruch 1, wobei das aliphatische Urethan-Acryloligomer mehr als 10 Gew.-% aber weniger als 40 Gew.-% der oleophilen Abbildungsschicht nach Trocknung, oder bevorzugt mehr als 10 Gew.-% aber weniger als 25 Gew.-% der oleophilen Abbildungsschicht nach Trocknung ausmacht.

5. Verfahren nach Anspruch 1, wobei die polymerisierbare Komponente ferner ein Nicht-Urethanmonomer umfasst.

6. Verfahren nach Anspruch 5, wobei ein Gewichtsverhältnis zwischen dem aliphatischen Urethan-Acryloligomer und dem Nicht-Urethanmonomer in der polymerisierbaren Komponente in dem Bereich zwischen 1:1,5 und 1:6 oder bevorzugt in dem Bereich zwischen 1:1,5 und 1:4 liegt oder bevorzugter wobei das Gewichtsverhältnis gleich 1:3 ist.

7. Verfahren nach Anspruch 5, wobei das aliphatische Urethan-Acryloligomer und das Monomer zusammen 60 bis 80 Gew.-% der oleophilen Abbildungsschicht nach Trocknung ausmachen.

8. Verfahren nach einem der vorhergehenden Ansprüche, ferner umfassend den Schritt des Anwendens der oleophilen Abbildungsschicht auf die erste hydrophile Schicht, ohne Wasser zu verwenden.

9. Verfahren nach einem der vorhergehenden Ansprüche, wobei die erste hydrophile Schicht gekörnt, anodisiert und nach dem Anodisieren mit Natriumsilikat behandelt wird.

10. Lithographisches Druckelement, umfassend:
eine erste hydrophile Schicht; und
eine über die erste Schicht angeordnete oleophile Abbildungsschicht, umfassend (i) eine Komponente, welche durch einen Freiradikalpolymerisationsmechanismus polymerisierbar ist, (ii) einen Initiator, welcher auf Abbildungsstrahlung anspricht, um freie Radikale zu erzeugen, um die Polymerisation der polymerisierbaren Komponente zu starten, (iii) einen Nah-IR-Absorber, und (iv) ein polymeres Bindungsmittel, wobei
die polymerisierbare Komponente ein nicht partikelförmiges aliphatisches Urethan-Acryloligomer umfasst, welches unbegrenzt wasserverdünnbar aber nicht wasserlöslich ist.

11. Druckelement nach Anspruch 10, wobei ein Gewichtsanteil von Acrylatgruppen in dem Urethan-Acryloligomer in dem Bereich zwischen 5 und 30 Gew.-% oder bevorzugt in dem Bereich zwischen 10 und 30 Gew.-% liegt.

12. Druckelement nach Anspruch 10, wobei die polymerisierbare Komponente im Wesentlichen aus dem nicht partikelförmigen aliphatischen Urethan-Acryloligomer besteht, welches unbegrenzt wasserverdünnbar aber nicht wasserlöslich ist.

13. Druckelement nach Anspruch 10, wobei das aliphatische Urethan-Acryloligomer mehr als 10 Gew.-% aber weniger als 40 Gew.-% der oleophilen Abbildungsschicht nach Trocknung, oder bevorzugt mehr als 10 Gew.-% aber weniger als 25 Gew.-% der oleophilen Abbildungsschicht nach Trocknung ausmacht.

14. Druckelement nach Anspruch 10, wobei die polymerisierbare Komponente ferner ein Nicht-Urethanmonomer umfasst, optional wobei ein Gewichtsverhältnis zwischen dem aliphatischen Urethan-Acryloligomer und dem Nicht-Urethanmonomer in der polymerisierbaren Komponente in dem Bereich zwischen 1:1,5 und 1:6 oder bevorzugt in dem Bereich zwischen 1:1,5 und 1:4 liegt oder bevorzugter wobei das Gewichtsverhältnis gleich 1:3 ist.

15. Druckelement nach Anspruch 14, wobei das aliphatische Urethan-Acryloligomer und das Monomer zusammen 60 bis 80 Gew.-% der oleophilen Abbildungsschicht nach Trocknung ausmachen.

16. Druckelement nach Anspruch 10, wobei die Abbildungsschicht ein trockenes Beschichtungsgewicht von weniger als 1 g/m² aufweist.

17. Druckelement nach Anspruch 10, wobei der Initiator ein Oniumsalz ist.

18. Druckelement nach Anspruch 10, ferner umfassend eine wasserlösliche oder wasserdispergierbare Deckschicht über die oleophile Abbildungsschicht umfasst, optional wobei die Deckschicht ein trockenes Beschichtungsgewicht von nicht mehr als 0,4 g/m² aufweist und optional wobei die Deckschicht eine Dispersion von Partikeln eines Poly-(Urethan-Acryl)-Hybrids umfasst.

## Revendications

1. Procédé de préparation et d'impression avec un élément d'impression lithographique, le procédé comprenant les étapes consistant à :
fournir un élément d'impression lithographique comprenant :
(a) une première couche hydrophile ; et
(b) disposée sur la première couche, une couche d'imagerie oléophile comprenant (i) un composant polymérisable par un mécanisme de polymérisation radicalaire libre, (ii) un amorceur pour générer, lors d'une exposition à un rayonnement d'imagerie, des radicaux libres pour amorcer la polymérisation du composant polymérisable, (iii) un absorbeur proche IR, et (iv) un lieur polymère, le composant polymérisable comprenant un oligomère acrylique d'uréthane aliphatique non particulaire qui est diluable dans l'eau de manière infinie, mais non soluble dans l'eau ;
exposer l'élément d'impression à un rayonnement d'imagerie infrarouge dans un schéma sous forme d'image pour provoquer la polymérisation du composant polymérisable ; et
imprimer avec l'élément d'impression pour éliminer uniquement les parties non exposées de la couche d'imagerie sans agent de développement pendant une phase de mise en route, et ensuite pour produire une copie imprimée.

2. Procédé selon la revendication 1, dans lequel un pourcentage en poids de groupes acrylate dans l'oligomère acrylique d'uréthane est compris dans la plage allant de 5 à 30 % en poids ou de préférence dans la plage allant de 10 à 30 % en poids.

3. Procédé selon la revendication 1, dans lequel le composant polymérisable se compose essentiellement de l'oligomère acrylique d'uréthane aliphatique non particulaire qui est diluable dans l'eau de manière infinie, mais non soluble dans l'eau.

4. Procédé selon la revendication 1, dans lequel l'oligomère acrylique d'uréthane aliphatique constitue plus de 10 % en poids, mais moins de 40 % en poids, de la couche d'imagerie oléophile après séchage, ou de préférence plus de 10 % en poids, mais moins de 25 % en poids, de la couche d'imagerie oléophile après séchage.

5. Procédé selon la revendication 1, dans lequel le composant polymérisable comprend en outre un monomère autre qu'un uréthane.

6. Procédé selon la revendication 5, dans lequel un rapport en poids de l'oligomère acrylique d'uréthane aliphatique au monomère autre qu'un uréthane dans le composant polymérisable est compris dans la plage allant de 1:1,5 à 1:6, ou de préférence dans la plage allant de 1:1,5 à 1:4, ou plus préférablement dans lequel le rapport en poids est 1:3.

7. Procédé selon la revendication 5, dans lequel l'oligomère acrylique d'uréthane aliphatique et le monomère constituent collectivement 60 à 80 % en poids de la couche d'imagerie oléophile après séchage.

8. Procédé selon l'une quelconque des revendications précédentes, comprenant en outre l'étape consistant à appliquer la couche d'imagerie oléophile sur la première couche hydrophile sans utiliser d'eau.

9. Procédé selon l'une quelconque des revendications précédentes, dans lequel la première couche hydrophile est grainée, anodisée et traitée post-anodiquement avec du silicate de sodium.

10. Élément d'impression lithographique comprenant :
une première couche hydrophile ; et
disposée sur la première couche, une couche d'imagerie oléophile comprenant (i) un composant polymérisable par un mécanisme de polymérisation radicalaire libre, (ii) un amorceur sensible à un rayonnement d'imagerie pour générer des radicaux libres pour amorcer la polymérisation du composant polymérisable, (iii) un absorbeur proche IR, et (iv) un lieur polymère, dans lequel
le composant polymérisable comprenant un oligomère acrylique d'uréthane aliphatique non particulaire qui est diluable dans l'eau de manière infinie, mais non soluble dans l'eau.

11. Élément d'impression selon la revendication 10, dans lequel un pourcentage en poids de groupes acrylate dans l'oligomère acrylique d'uréthane est compris dans la plage allant de 5 à 30 % en poids, ou de préférence dans la plage allant de 10 à 30 % en poids.

12. Élément d'impression selon la revendication 10, dans lequel le composant polymérisable se compose essentiellement de l'oligomère acrylique d'uréthane aliphatique non particulaire qui est diluable dans l'eau de manière infinie, mais non soluble dans l'eau.

13. Élément d'impression selon la revendication 10, dans lequel l'oligomère acrylique d'uréthane aliphatique constitue plus de 10 % en poids, mais moins de 40 % en poids, de la couche d'imagerie oléophile après séchage, ou de préférence plus de 10 % en poids, mais moins de 25 % en poids, de la couche d'imagerie oléophile après séchage.

14. Élément d'impression selon la revendication 10, dans lequel le composant polymérisable comprend en outre un monomère autre qu'un uréthane, optionnellement dans lequel un rapport en poids de l'oligomère acrylique d'uréthane aliphatique au monomère autre qu'un uréthane dans le composant polymérisable est compris dans la plage allant de 1:1,5 à 1:6, ou de préférence dans la plage allant de 1:1,5 à 1:4, ou plus préférablement dans lequel le rapport en poids est 1:3.

15. Élément d'impression selon la revendication 14, dans lequel l'oligomère acrylique d'uréthane aliphatique et le monomère constituent collectivement 60 à 80 % en poids de la couche d'imagerie oléophile après séchage.

16. Élément d'impression selon la revendication 10, dans lequel la couche d'imagerie a un poids de revêtement sec inférieur à 1 g/m².

17. Élément d'impression selon la revendication 10, dans lequel l'amorceur est un sel d'onium.

18. Élément d'impression selon la revendication 10, comprenant en outre une couche de finition soluble dans l'eau ou dispersible dans l'eau sur la couche d'imagerie oléophile, optionnellement dans lequel la couche de finition a un poids de revêtement sec non supérieur à 0,4 g/m² et optionnellement dans lequel la couche de finition comprend une dispersion de particules d'un hybride poly(uréthane-acrylique).
